Europäisches Patentamt

European Patent Office

Office européen des brevets

(19)

(11) Publication number:  **0 230 385 B1**

# EUROPEAN PATENT SPECIFICATION

(12)

(45) Date of publication of patent specification: **29.12.93**  (51) Int. Cl.⁵: **G11C 11/409**, G11C 11/24

(21) Application number: **87300389.1**

(22) Date of filing: **16.01.87**

(54) **Semiconductor memory.**

(30) Priority: **17.01.86 JP 7271/86**

(43) Date of publication of application:
**29.07.87 Bulletin  87/31**

(45) Publication of the grant of the patent:
**29.12.93 Bulletin  93/52**

(84) Designated Contracting States:
**DE FR GB**

(56) References cited:
**WO-A-81/02358**

**IEEE INTERNATIONAL SOLID-STATE CIR-
CUITS CONFERENCE, DIGEST OF TECHNICAL
PAPERS, 24th February 1984, pages
278-279,354, IEEE, New York, US; R.I. KUNG et
al.: "A sub 100ns 256K DRAM in CMOS III
technology"**

**PATENT ABSTRACTS OF JAPAN, vol. 8, no.
38 (P-255)[1475], 18th February 1984; & JP-
A-58 189 898 (TOKYO SHIBAURA DENKI K.K.)
05-11-1983**

(73) Proprietor: **KABUSHIKI KAISHA TOSHIBA
72, Horikawa-cho
Saiwai-ku
Kawasaki-shi Kanagawa-ken 210(JP)**

Proprietor: **Toshiba Micro-Computer Engi-
neering Corporation
2-11, Higashida-cho
Kawasaki-ku
Kawasaki-shi Kanagawa-ken(JP)**

(72) Inventor: **Ogihara, Masaki c/o Patent Division
Toshiba Corp. Prin. Office
1-1 Shibaura 1-chome
Minato-ku Tokyo(JP)**
Inventor: **Okada, Yoshio c/o Patent Division
Toshiba Corp. Prin. Office
1-1 Shibaura 1-chome
Minato-ku Tokyo(JP)**
Inventor: **Fujii, Shuso c/o Patent Division
Toshiba Corp. Prin. Office
1-1 Shibaura 1-chome
Minato-ku Tokyo(JP)**

(74) Representative: **Freed, Arthur Woolf et al
MARKS & CLERK
57-60 Lincoln's Inn Fields
London WC2A 3LS (GB)**

EP 0 230 385 B1

**IBM TECHNICAL DISCLOSURE BULLETIN, vol. 17, no. 6, November 1974, pages 1797-1798, New York, US; D.P. SPAMPINATO: "Differential sense amplifier"**

**PATENT ABSTRACTS OF JAPAN, vol. 3, no. 85 (E-124), 21st July 1979, page 131 E 124; & JP-A-54 63 632 (HITACHI SEISAKUSHO K.K.) 22-05-1979**

**IEEE Journal of Solid-State Circuits, vol. SC-13, no. 5, 1978, p. 708-711**

## Description

This invention relates to a semiconductor memory. In particular, it relates to a memory of the kind comprising a memory cell for storing data, a bit line pair for transferring the data to and from the memory cell, a sense amplifier comprising MOS transistors of first conductivity type, the sense amplifier being coupled to the bit line pair for amplifying the data, a restore circuit comprising MOS transistors of second conductivity type, the restore circuit being coupled to the bit line pair for restoring the data, and barrier transistor means comprising MOS-transistors of the first conductivity type, the barrier transistor means being inserted into the bit line pair to divide the bit line pair into a first section and a second section, wherein the memory cell and the restore circuit are connected to the first section and the sense amplifier is connected to the second section.

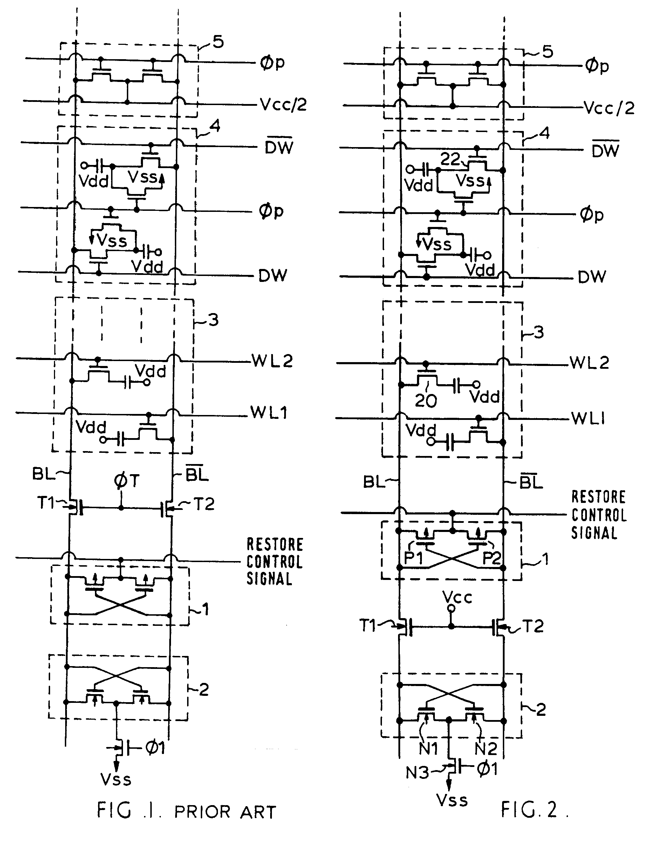

As shown in Figure 1, in conventional memories of this type, for instance the dynamic RAM (random access memory), barrier transistors T1 and T2 formed by N channel MOS transistors are inserted in series at one end of the bit line pair BL and $\overline{BL}$ of each column in the memory cell array 3 and the dummy cell circuit 4. Restore circuit 1 and synchronized sense amplifier 2 are connected to the bit line pair section on the opposite side of the memory cell array 3 using barrier transistors T1 and T2 as a reference. This sense amplifier 2 operates the sense amplification and latch action by receiving synchronization singal $\phi$1. A precharge equalizer circuit 5 is connected to the other end of the bit line pair BL and $\overline{BL}$.

As is well known, for reading the memory cell data in a dynamic RAM, sense amplifier 2 reads the slight difference in potential which is generated in the bit line pair BL and $\overline{BL}$ by amplifying it and determines data "1" or "0". However, a problem arises in that the more the integration of dynamic RAMs progresses, the greater becomes the load capacity of bit lines BL and $\overline{BL}$ and the longer the sensing time becomes. Therefore, to counteract this, a resistance component due to the barrier transistors T1 and T2 is inserted between bit lines BL and $\overline{BL}$ and sense amplifier 2 so that latching of the bit line potential by sense amplifier 2 is made faster.

A barrier control signal $\phi$T is applied to the gates of barrier transistors T1 and T2. The potentials shown in the following Table are used for this signal $\phi$T according to the bit line precharge system.

| Bit line precharge potential | Sensing | Restoring | Precharging |
|---|---|---|---|
| Vcc (Power source potential) | >Vcc+VT | >Vcc+VT | >Vcc+VT |
| Vss (Earth potential) | Vcc | >Vcc+VT | Vcc |
| Vcc/2 | Vcc | >Vcc+VT | Vcc |

Here, VT is the threshold voltage of barrier transistors T1 and T2. Accordingly, when restoring, it is necessary to make the bit line potential Vcc. Thus, at this time, in order to set barrier transistors T1 and T2 to the ON state, each system requires a greater potential than (Vcc + VT) as the $\phi$T potential. In this case, in the Vss precharge system and the Vcc/2 system, it is necessary to step up the potential so that $\phi$T is ≥Vcc + VT during restoring, which is different from other periods.

In the conventional memories mentioned above, a voltage step-up circuit (not shown in the Figure) is required as a memory peripheral circuit in order to generate the control signal $\phi$T. This leads to accompanying problems in that the design and construction are more complicated, the area occupied on the memory chip surface is increased and, consequently, the area of the memory chip is increased.

One known arrangement of a memory cell with a sense amplifier and a restore circuit connected in a bit line pair as described in the above opening paragraph is disclosed in IEEE Iht. Solid State Circuits Confenrence, Digest of Technical Papers 24 Feb. 1984 pp 278-279, 354. A known differential sense implifier circuit is disclosed in IBM Technical Disclosure Bulletin, vol. 17, no. 6, Nov 1974 pp 1797-1798.

An object of this invention is to provide a semiconductor memory in which the gate potential of the barrier transistors is constant, and to eliminate the need for a step-up circuit for the barrier transistor control signal. Thus, the design can be simplified, the circuit can be more easily constructed and the required chip surface area can be decreased.

The semiconductor memory of this invention has the characterising feature that said MOS transistors of the barrier transistor means have gates connected to a constant voltage and sources and drains respectively connected in series with said bit line pair between said first and second sections so that said amplified data are delivered to the exterior via said second section and the barrier transistor means reduces the load capacity of the sense amplifier.

In this way, there is not loss of efficiency from the insertion of the barrier transistors and therefore a step-up circuit for the barrier transistor control signal is no longer required.

Figure 1 is a circuit diagram showing a part of a conventional dynamic RAM.

Figure 2 is a circuit diagram showing a part of a Vcc/2 precharge system dynamic RAM of an embodiment of this invention.

An embodiment of this invention is explained in detail below with reference to drawings.

Figure 2 shows the circuit connections of restore circuit 1, barrier transistors T1 and T2 and synchronized sense amplifier 2 for the bit line pair BL and $\overline{BL}$ which correspond to 1 column In the memory cell array 3 of, for instance, a Vcc/2 precharge system dynamic RAM. The device of Figure 1 differs from the circuit connections described above in two major respects. The first difference is that restore circuit 1 is directly connected to bit line pair BL and $\overline{BL}$ (that is to say, taking barrier transistors T1 and T2 as a reference, it is connected on the memory cell side). The second point is that a constant potential, for instance power source potential Vcc, is applied to the gates of barrier transistors T1 and T2. The same symbols as appear in Fig. 1 are used for the other components shown in Fig. 2.

This embodiment shows the case of a CMOS (complementary insulated gate) memory. Sense amplifier 2 is connected in such a way that two N channel enhancement MOS transistors N1 and N2, form a flipflop circuit. Thus, the operating and non-operating states are controlled by N channel enhancement MOS transistor N2 whose switching is in turn controlled by sense amplifier control signal $\phi$1. Also, N channel enhancement MOS transistors are used for barrier transistors T1 and T2. Moreover, restore circuit 1 is connected in such a way that two P channel enhancement MOS transistors $P_1$ and $P_2$ form a flipflop circuit. Thus, the operating and non-operating states are controlled by the restore control signal.

The following are explanations of the operation of the above circuits.

(1) When precharge operates, since gate potential Vcc of barrier transistors T1 and T2 is higher than bit line precharge potential Vcc/2 + threshold voltage VT of barrier transistors T1 and T2, barrier transistors T1 and T2 are in the ON states. Therefore no interference occurs to the bit line precharge operation through the precharge circuit 5.

(2) When the memory cell data is read, sense amplifier control signal $\phi$1 becomes high level and sense amplifier 2 carries out sense amplification of the potential difference generated between bit line pair BL and $\overline{BL}$. This is the difference between the potential generated in one bit line BL through the holding charge of the memory cell 20 selected in accordance with the address input and the potential generated in this bit line $\overline{BL}$ by a selected dummy cell 22 which is connected to the other bit line $\overline{BL}$. Next, restore circuit 1 operates and restores the bit line pair. Since restore circuit 1 is installed directly on bit line pair BL and $\overline{BL}$, it is possible to step-up the bit line potential sufficiently to the required level of Vcc potential, even though the gate potential of barrier transistors T1 and T2 is only Vcc potential.

(3) When writing data to a memory cell, sense amplifier 2 is operated and the high/low relationship of the potentials of bit lines BL and $\overline{BL}$ is determined according to the write input data. In this case, even if the selected memory data is reversed from "1" to "0" or from "0" to "1", when the potential relationship of bit lines BL and $\overline{BL}$ is reversed by sense amplifier 2, this bit line potential passes through barrier transistors T1 and T2 and reverses restore circuit 1. Then it is possible to step up the bit line potential to Vcc potential by restore circuit 1.

Since, in the above memory, the gate potential of barrier transistors T1 and T2 can be set at Vcc potential, a barrier transistor control signal step-up circuit is no longer required. Therefore circuit design and pattern design are much simpler, circuit construction is easier and chip surface area can be decreased.

Moreover, by connecting restore circuit 1 directly to the bit lines pair, since the load capacity of sense amplifier 2 is reduced at least by the capacity of restore circuit 1 compared with conventional examples, the sensing time of sense amplifier 2 becomes shorter (sensing becomes faster) because it is almost proportional to the load capacity.

Also, the resistance from restore circuit 1 to the far end of bit line pair BL and $\overline{BL}$ in conventional circuits is large, since the resistance of the bit line itself and the resistance component of barrier transistors T1 and T2 are connected in series. However, in this embodiment this resistance component is only the resistance of the bit line. Therefore, because the restore time of the bit line is almost proportional to the above resistance, the restore time decreases in this embodiment in comparison to in conventional examples. As a result, it becomes possible to speed up the operation, particularly when data writing, and a speed-up of memory operation can be achieved.

This invention is not confined to the above embodiment. The same effect as in the embodiment can also be obtained even when the sense amplifier is constructed using P channel MOS transistors. In this case P channel MOS transistors are used for the barrier transistors and Vss potential (earth potential) is applied to their gates. Also, selection of an appropriate active level for the restore control signal makes restoring possible irrespective of whether P channel transistors or N channel transistors are used. This applies to all memories, whether they be NMOS memories, PMOS memories or CMOS memories.

As described above, when a semiconductor memory of this invention is used, a step-up circuit for the barrier transistor control signal is no longer required, because the restore circuit is connected directly to the bit line by providing barrier transistors between the sense amplifier and the restore circuit and applying a constant potential (Vcc potential or Vss potential) on their gates. Therefore, simplification of design and circuit construction can be achieved and the chip surface area can be made smaller. Furthermore, since sensing and restoring can be speeded up, this invention is suitable for high integration and large storage memories.

Various modifications and variations could be made to the invention without departing from the scope of the invention.

## Claims

1. A semiconductor memory comprising:
   a memory cell for storing data;
   a bit line pair (BL, $\overline{BL}$) for transferring the data from and to the memory cell;
   a sense amplifier (2) comprising MOS transistors (N1, N2) of first conductivity type, the sense amplifier being coupled to the bit line pair for amplifying the data;
   a restore circuit (1) comprising MOS transistors (P1, P2) of second conductivity type, the restore circuit being coupled to the bit line pair for restoring the data; and
   barrier transistor means comprising MOS transistors (T1, T2) of the first conductivity type, the barrier transistor means being inserted into the bit line pair to divide the bit line pair into a first section and a second section, wherein the memory cell and the restore circuit are connected to the first section and the sense amplifier is connected to the second section, characterised in that said MOS transistors (T1, T2) of the barrier transistor means have gates connected to a constant voltage ($V_{cc}$, $V_{ss}$) and sources and drains respectively connected in series with said bit line pair (BL, $\overline{BL}$) between said first and second sections so that said amplified data are delivered to the exterior via said second section and the barrier transistor means reduces the load capacity of the sense amplifier.

2. A semiconductor memory according to claim 1, further characterised in that said sense amplifier comprises two of said MOS transistors (N1, N2) of the first conductive type having sources to which a first potential (Vss) is applied, the drains of each being coupled to a respective one of the bit lines (BL, $\overline{BL}$) and the gates of each being coupled to an alternate respective one of the bit lines ($\overline{BL}$, BL).

3. A semiconductor memory according to claim 2, further characterised in that the MOS transistors (T1, T2) of the barrier transistor means are N channel transistors and said constant voltage applied to their gates is a power source potential (Vcc).

4. A semiconductor memory according to claim 2, further characterised in that the MOS transistors of the barrier transistor means are P channel transistors and said constant voltage applied to their gates is earth potential (Vss).

5. A semiconductor memory according to any preceding claim, further characterised by being adapted for a dynamic memory device having a Vcc/2 precharge system.

6. A semiconductor memory according to any preceding claim, further characterised in that the restore circuit (1) comprises two of said MOS transistors (P1, P2) of the second conductivity type, having sources arranged to be applied with a restore control signal, the drains of each being coupled to a respective one of the bit lines (BL, $\overline{BL}$) and the gates of each being coupled to an alternate respective one of said bit lines ($\overline{BL}$, BL).

## Patentansprüche

1. Halbleiterspeicher mit:
   einer Speicherzelle zum Speichern von Daten;
   einem Bitleitungspaar (BL, $\overline{BL}$) zum Übertragen der Daten aus der und in die Speicherzelle;
   einem Leseverstärker (2) mit MOS-Transistoren (N1, N2) eines ersten Leitfähigkeitstyps, wobei der Leseverstärker zum Verstärken der Daten an das Bitleitungspaar gekoppelt ist;

einer Rückspeicherschaltung (1) mit MOS-Transistoren (P1, P2) eines zweiten Leitfähigkeitstyps, wobei die Schaltung zum Rückspeichern der Daten an das Bitleitungspaar gekoppelt ist; und

einer Barrier-Transistoreinrichtung mit MOS-Transistoren (T1, T2) des ersten Leitfähigkeitstyps, wobei die Barrier-Transistoreinrichtung in das Bitleitungspaar eingefügt ist, um das Bitleitungspaar in einen ersten Abschnitt und in einen zweiten Abschnitt zu teilen, wobei die Speicherzelle und die Rückspeicherschaltung mit dem ersten Abschnitt verbunden sind und der Leseverstärker mit dem zweiten Abschnitt verbunden ist, dadurch gekennzeichnet, daß die MOS-Transistoren (T1, T2) der Barrier-Transistoreinrichtung über ihre Gates mit einer Konstantspannung ($V_{cc}$, $V_{ss}$) verbunden sind und über ihre Sources und Drains jeweils mit dem Bitleitungspaar (BL, $\overline{BL}$) zwischen den ersten und den zweiten Abschnitt in Reihe geschaltet sind, so daß die verstärkten Daten über den zweiten Abschnitt nach draußen abgegeben werden und die Barrier-Transistoreinrichtung die Lastkapazität des Leseverstärkers verringert.

2. Halbleiterspeicher nach Anspruch 1, ferner dadurch gekennzeichnet, daß der Leseverstärker zwei der MOS-Transistoren (N1, N2) des ersten Leitfähigkeitstyps mit Sources aufweist, an die ein erstes Potential (Vss) angelegt wird, wobei deren beider Drains an eine entsprechende der Bitleitung (BL, $\overline{BL}$) und deren beider Gates an eine andere entsprechende der Bitleitungen ($\overline{BL}$, BL) gekoppelt sind.

3. Halbleiterspeicher nach Anspruch 2, ferner dadurch gekennzeichnet, daß die MOS-Transistoren (T1, T2) der Barrier-Transistoreinrichtung n-Kanal-Transistoren sind und die Konstantspannung, die an ihre Gates angelegt wird, ein Stromquellenpotential (Vcc) ist.

4. Halbleiterspeicher nach Anspruch 2, ferner dadurch gekennzeichnet, daß die MOS-Transistoren der Barrier-Transistoreinrichtung p-Kanal-Transistoren sind und die Konstantspannung, die an ihre Gates angelegt wird, Massepotential (Vss) ist.

5. Halbleiterspeicher nach einem der vorangegangenen Ansprüche, ferner dadurch gekennzeichnet, daß er für eine dynamische Speichereinrichtung mit einem Vcc/2-Voraufladungssystem geeignet ist.

6. Halbleiterspeicher nach einem der vorangegangenen Ansprüche, ferner dadurch gekennzeichnet, daß die Rückspeicherschaltung (1) zwei der MOS-Transistoren (P1, P2) des zweiten Leitfähigkeitstyps aufweist, deren Sources so eingerichtet sind, daß ein Rückspeicherungssteuersignal angelegt werden kann, deren beider Drains an eine entprechende der Bitleitungen (BL, $\overline{BL}$) und deren beider Gates an eine andere entsprechende der Bitleitungen ($\overline{BL}$, BL) gekoppelt sind.

**Revendications**

1. Mémoire à semi-conducteurs comprenant :

une cellule de mémoire pour mettre des données en mémoire;

une paire de lignes de bits (BL, $\overline{BL}$) pour transférer les données dans la cellule à mémoire et les extraire de celle-ci;

un amplificateur de sens (2) comprenant des transistors MOS (N1, N2) à conductivité du premier type, l'amplificateur de sens étant couplé à la paire de lignes de bits pour amplifier les données;

un circuit de remise en mémoire (1) comprenant des transistors MOS (P1, P2) à conductivité du deuxième type, le circuit de remise en mémoire étant couplé à la paire de lignes de bits pour remettre les données en mémoire; et

un moyen à transistors de barrière comprenant des transistors MOS (T1, T2) à conductivité du premier type, le moyen à transistors de barrière étant inséré dans la paire de lignes de bits pour diviser la paire de lignes de bits en une première section et une deuxième section dans laquelle la cellule de mémoire et le circuit de remise en mémoire sont connectés à la première section et dans laquelle l'amplificateur de sens est connecté à la deuxième section, caractérisée en ce que lesdits transistors MOS (T1, T2) du moyen à transistors de barrière ont des portes connectées à une tension constante ($V_{cc}$, $V_{ss}$) et des sources et des drains connectés respectivement en série à ladite paire de lignes de bits (BL, $\overline{BL}$) entre lesdites première et deuxième sections, de façon que lesdites données amplifiées soient envoyées à l'extérieur en passant par ladite deuxième section et que le moyen à transistors de barrière diminue la capacité de charge de l'amplificateur de sens.

EP 0 230 385 B1

**2.** Mémoire à semi-conducteurs selon la revendication 1, caractérisée en outre en ce que ledit amplificateur de sens comprend deux desdits transistors MOS (N1, N2) à conductivité du premièr type ayant des sources auxquelles est appliqué un premier potentiel ($V_{ss}$), les drains de chacune étant couplés à l'une des lignes de bits correspondantes (BL, $\overline{BL}$) et les portes de chacune étant couplées à l'autre ligne de bits correspondante ($\overline{BL}$, BL).

**3.** Mémoire à semi-conducteurs selon la revendication 2, caractérisée en outre en ce que les transistors MOS (T1, T2) du moyen à transistors de barrière sont des transistors à canal N et que ladite tension constante appliquée à leurs portes est un potentiel de source de puissance ($V_{cc}$).

**4.** Mémoire à semi-conducteurs selon la revendication 2, caractérisée en outre en ce que les transistors MOS du moyen à transistors de barrière sont des transistors à canal P et que ladite tension constante appliquée à leurs portes est le potentiel de terre ($V_{ss}$).

**5.** Mémoire à semi-conducteurs selon l'une quelconque des revendications précédentes, caractérisée en outre par le fait qu'elle est adaptée à un dispositif à mémoire dynamique ayant un système de pré-chargement (Vcc/2).

**6.** Mémoire à semi-conducteurs selon l'une quelconque des revendications précédentes, caractérisée en outre en ce que le circuit de remise en mémoire (1) comprend deux desdits transistors MOS (P1, P2) à conductivité du deuxième type ayant des sources disposées pour être appliquées avec un signal de commande de la remise en mémoire, les drains de chacune d'elles étant couplés à l'une des lignes de bits correspondantes (BL, $\overline{BL}$) et les portes de chacune d'elles étant couplées à l'autre des lignes de bits correspondante ($\overline{BL}$, BL).

FIG.1. PRIOR ART

FIG.2.